# EUROPÄISCHE PATENTSCHRIFT

(11) **EP 4 060 097 B1**
(45) Veröffentlichungstag und Bekanntmachung des Hinweises auf die Patenterteilung: **01.05.2024**
(21) Anmeldenummer: 21162749.2
(22) Anmeldetag: 16.03.2021
(51) Int. Cl.: C30B 15/04, C30B 29/06

(54) **VORRICHTUNG UND VERFAHREN ZUR HERSTELLUNG EINES DOTIERTEN MONOKRISTALLINEN STABES AUS SILICIUM**
DEVICE AND METHOD OF MANUFACTURING A DOPED SILICON MONOCRYSTALLINE ROD
DISPOSITIF ET PROCÉDÉ DE PRODUCTION D'UNE TIGE MONOCRYSTALLINE DOPÉE EN SILICIUM

(43) Veröffentlichungstag der Anmeldung: 21.09.2022
(73) Patentinhaber: Siltronic AG, 81677 München (DE)
(72) Erfinder: Knerer, Dieter, 84533 Haiming (DE); Eschenbacher-Bladt, Patrick, 84489 Burghausen (DE); Gattermann, Ulf, 84359 Simbach am Inn (DE)

(56) Entgegenhaltungen:
- EP-A1- 0 170 856
- WO-A1-2020/123074

## Beschreibung

Gegenstand der Erfindung ist ein Verfahren zur Herstellung eines monokristallinen Stabes aus Silizium, umfassend das Aufschmelzen von Polysilicium in einem Tiegel, Dotieren des Siliziums und Ziehen eines Einkristalls an einem Impfkristall aus einer in einem Tiegel erhitzten Schmelze nach Czochralski.

Einkristallines Silizium, das als Ausgangsmaterial für die meisten Verfahren zur Herstellung von elektronischen Halbleiterbauelementen ist, wird üblicherweise nach dem sogenannten Czochralski-Verfahren ("CZ") hergestellt. Bei diesem Verfahren wird polykristallines Silizium ("Polysilizium") in einen Tiegel gegeben und geschmolzen, ein Impfkristall wird mit dem geschmolzenen Silizium in Kontakt gebracht und ein Einkristall wird durch langsame Extraktion gezüchtet.

Der Tiegel besteht üblicherweise aus einem Siliziumdioxid enthaltenden Material wie Quarz. Er wird in der Regel mit Bruchstücken und/oder mit Granulat aus polykristallinem Silizium gefüllt, das mit Hilfe eines um den Tiegel herum angeordneten Seitenheizers und eines unter dem Tiegel angeordneten Bodenheizers geschmolzen wird. Nach einer Phase der thermischen Stabilisierung der Schmelze wird ein einkristalliner Impfkristall in die Schmelze getaucht und angehoben. Dabei kristallisiert Silizium am von der Schmelze benetzten Ende des Impfkristalls. Die Kristallisationsgeschwindigkeit wird im Wesentlichen durch die Geschwindigkeit beeinflusst, mit der der Impfkristall angehoben wird (Kristallhubgeschwindigkeit) und von der Temperatur an der Grenzfläche, an der geschmolzenes Silizium kristallisiert. Durch geeignete Steuerung dieser Parameter wird zunächst ein als Dünnhals ("neck") bezeichneter Abschnitt gezogen, um Versetzungen zu beseitigen, dann ein konusförmiger Abschnitt des Einkristalls und schließlich ein zylindrischer Abschnitt des Einkristalls, von dem später die Halbleiterscheiben abgetrennt werden.

Wie beispielsweise in US-5954873 A beschrieben, werden beim Kristallziehverfahren die entsprechenden Prozessparameter so eingestellt, dass eine radial homogene Defektverteilung im Kristall erreicht wird.

Insbesondere wird darauf geachtet, dass Agglomerate aus Leerstellen (Vakanzen), die auch COPs (**c**rystal **o**riginated **p**articles) genannt werden, nicht oder nur unter der Nachweisgrenze entstehen. Als Nachweisgrenze wird im Folgenden für COPs eine Dichte von 1000 Defekte/cm³ verstanden.

Gleichzeitig wird darauf geachtet, dass Agglomerate aus interstitiellen Siliziumatomen, die als LPITs benannt werden, nicht oder nur unter der Nachweisgrenze vorkommen. Als Nachweisgrenze wird im Folgenden eine Dichte von LPITs von 1 Defekt/cm² verstanden.

Bei einigen Anwendungen wird der Schmelze eine Menge Dotierstoff zugegeben, um einen gewünschten spezifischen Widerstand im Siliziumkristall zu erreichen. Konventionell wird der Dotierstoff aus einem Einfülltrichter, der sich einige Meter über dem Niveau der Siliziumschmelze befindet, in die Schmelze eingebracht. Diese Vorgehensweise ist jedoch für flüchtige Dotierstoffe ungünstig, da solche Dotierstoffe dazu neigen, unkontrolliert in die Umgebung zu verdampfen, was zur Bildung von Oxidpartikeln (d. h. Suboxiden) führen kann, die in die Schmelze fallen und in den wachsenden Kristall eingebaut werden können. Diese Partikel können als heterogene Keimbildungsstellen wirken und letztlich zum Versagen des Kristallziehprozesses durch Verursachen von zum Beispiel Versetzungen führen.

Einige bekannte Dotierstoffsysteme führen flüchtige Dotierstoffe als Gas in die Wachstumskammer ein. Solche Systeme müssen jedoch jedes Mal manuell nachgefüllt werden, wenn ein Dotiervorgang durchgeführt wird. Außerdem können solche Systeme nicht während des Betriebs nachgefüllt werden. Infolgedessen haben solche Systeme eine begrenzte Dotierstoff-Nutzlast für einen einzelnen Wachstumsprozess. Solche Systeme begrenzen daher die Größe von Siliziumblöcken, die gezüchtet werden können. Darüber hinaus neigen solche Systeme dazu, Dotierstoff während eines Wachstumsprozesses unkontrolliert zuzuführen, wodurch die Variation der Dotierstoffkonzentration in unkontrollierter Weise entlang der Längsachse eines gewachsenen Ingots erhöht wird.

Die WO 2009/113 441 A1 beschreibt ein Verfahren und eine Vorrichtung zum Dotieren von Silicium, wobei Dotierstoff sublimiert wird und gasförmig der Schmelze zugeführt wird.

In der WO 2014/141 309 A1 wird eine Vorrichtung zum Kristallziehen beschrieben, die ein Zufuhrsystem für Dotierstoff enthält, das eine Dotierstoffleitung enthält, die mit einem speziellen Kammersystem ausgestattet ist, so dass fester Dotierstoff nicht in die Schmelze fallen, gasförmiger Dotierstoff aber zur Schmelze gelangen kann.

Die WO 2020/123 074 A1 stellt eine Weiterentwicklung der vorhergehenden Schrift dar und beinhaltet statt des verwendeten Kammersystems ein poröses Trennelement, das in der Dotierstoffleitung angebracht ist. Das poröse Trennelement verhindert, dass feste Dotierstoffgranulate, die sich beim Sublimieren heftig bewegen, aus dem Kammersystem herausgeschleudert werden, wodurch sie in die Schmelze fallen und zum einen die Konsistenz des Dotierstoffprozesses beeinträchtigen und zum anderen wegen Partikelbildung zum Versetzten des Kristalls führen können.

Die Schrift EP 0170 856 A1 beschreibt eine Vorrichtung zum Nachchargieren von Silicium in einen Tiegel während des Kristallziehens unter Verwendung eines Förderbandes. Der Nachteil dieser Anordnung besteht darin, dass die Menge an nachdosiertem Silicium variieren kann und somit die Verwendung als Nachdosiereinheit für Dotierstoff nicht geeignet ist.

Es besteht daher ein Bedarf an verbesserten Dotierstoff-Zuführsystemen für die Dotierung einer Siliziumschmelze zur Herstellung eines dotierten Siliziumblocks nach dem Czochralski-Verfahren.

Die Aufgabe der Erfindung ist es daher, ein Verfahren und eine Vorrichtung zur Verfügung zu stellen, das es ermöglicht, einen monokristallinen Stab mittels des Czochralski Ziehverfahrens herzustellen, wobei die axiale Variation des Dotierstoffs minimal ist.

Die Aufgabe wird gelöst durch die in den Ansprüchen beschriebenen Verfahren und Vorrichtungen.

Die bezüglich der vorstehend aufgeführten Ausführungsformen des erfindungsgemäßen Verfahrens angegebenen Merkmale können entsprechend auf die erfindungsgemäßen Produkte übertragen werden. Umgekehrt können die bezüglich der vorstehend ausgeführten Ausführungsformen der erfindungsgemäßen Produkte angegebenen Merkmale entsprechend auf das erfindungsgemäße Verfahren übertragen werden. Diese und andere Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

### Kurzbeschreibung der Figuren

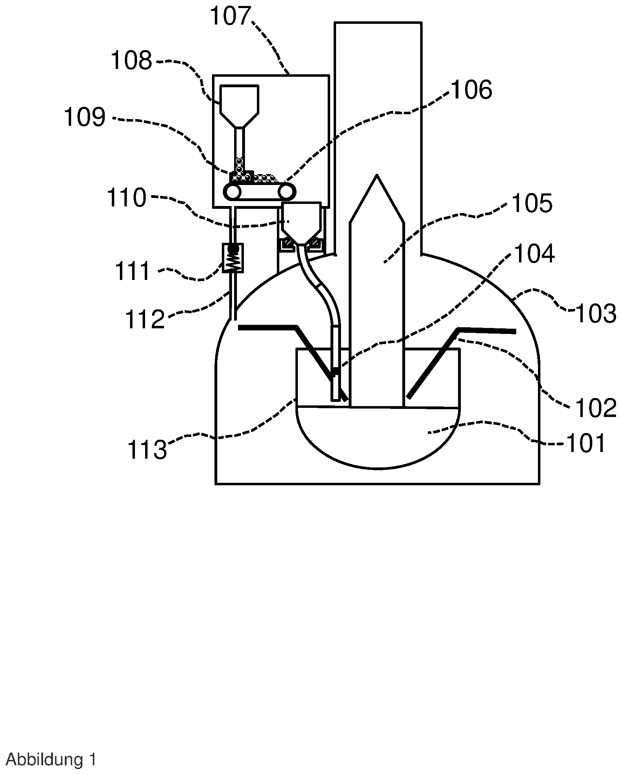

**Abbildung 1** zeigt die erfindungsgemäße Anordnung zum kontinuierlichen Dotieren von Silicium. Die Kristallziehanlage nach Czochralski beinhaltet einen Tiegel (**113**), der mit flüssigem Silicium (**101**) gefüllt ist und sich in einem Druckbehälter (**103**) befindet. Der Kristall (**105**) wird aus der Schmelze (**101**) gezogen, wobei ein oder mehrere Hitzeschilder (**102**) die Strahlungswärme begrenzen. Die Dotierung der Schmelze (**101**) findet statt, indem Dotierstoff aus einem Vorratsbehälter (**108**), der sich in einem Gehäuse (**107**) befindet, über ein Förderband (**106**) in einen Auffangtrichter (**110**) befördert wird, von dem es über ein Rohr auf ein poröses Trennelement (**104**) fällt. An der Position, an der sich das poröse Trennelement (**104**) befindet, herrschen Bedingungen, die zu einem Sublimieren des Dotierstoffes führen. Das so erhaltene Gas dotiert das flüssige Silicium und so den Kristall. Über dem Förderband ist eine Vorrichtung zum Formen des Schüttbetts auf dem Förderband (**109**) angebracht, die einen wohl definierten Schüttkegel des Dotierstoffes auf dem Förderband (**106**) formt, ohne dabei eine zusätzliche Kontamination zu verursachen. Über ein zusätzlich angebrachtes Ausgleichsventil (**111**) in einer Gasleitung zwischen Druckbehälter und Gehäuse (**112**) kann gegebenenfalls ein Druckausgleich zwischen Gehäuse und Druckbehälter durchgeführt werden.

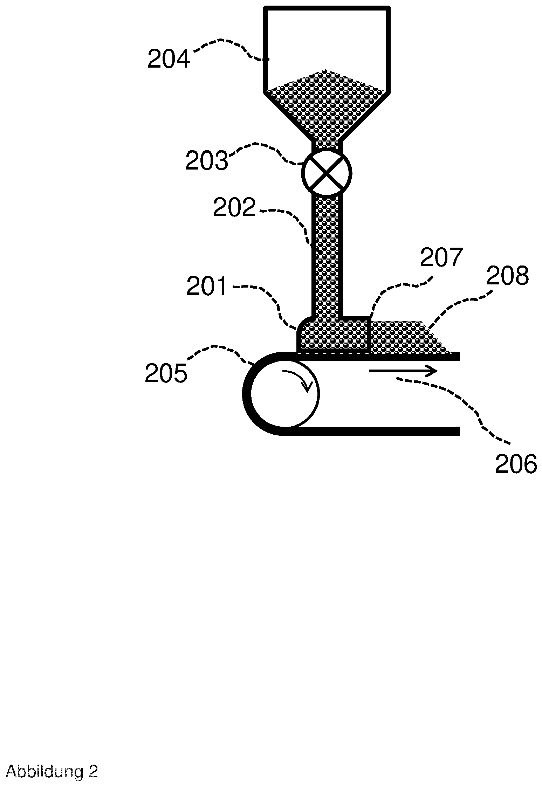

**Abbildung 2** zeigt den Vorratsbehälter (**204**), der mit Dotierstoff gefüllt ist. Über eine Absperrvorrichtung (**203**) kann der Dotierstoff in einem Verbindungsrohr (**202**) zur Vorrichtung zum Formen des Schüttbetts auf dem Förderband (**201**) gelangen, die dafür sorgt, dass auf dem Förderband (**205**) ein wohl definiertes Schüttbett des Dotierstoffes (**208**) geformt wird. Die offene Seite des Halbrohres der Vorrichtung zum Formen des Schüttbetts auf dem Förderband (**207**) zeigt dabei in Laufrichtung des Förderbandes (**206**).

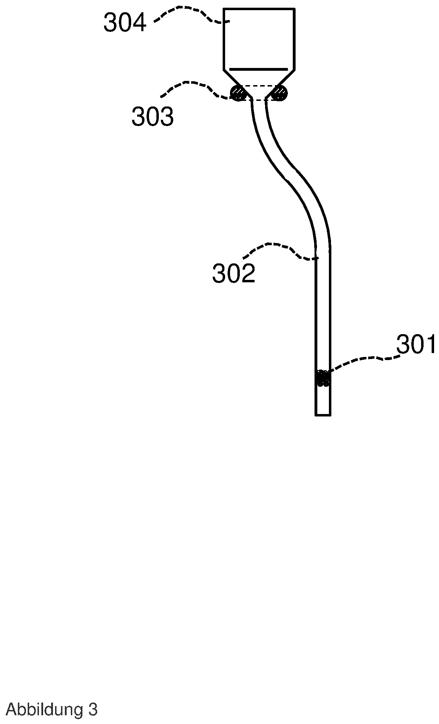

**Abbildung 3** zeigt die Verbindung zwischen dem Förderband und der Schmelze. Aus dem Förderband fällt der Dotierstoff in einen Auffangtrichter (**304**) und gelangt durch ein Rohr (**302**) zu einem porösen Trennelement (**301**) wo er sublimieren kann. Die Vorrichtung wird gehalten durch eine Haltevorrichtung (**303**).

### Abkürzungen

- 101: Schmelze aus Silicium
- 102: Hitzeschild
- 103: Druckbehälter
- 104: poröses Trennelement
- 105: Kristall
- 106: Förderband
- 107: Gehäuse
- 108: Vorratsbehälter
- 109: Vorrichtung zum Formen des Schüttbetts auf dem Förderband
- 110: Auffangtrichter, Auffangeinrichtung
- 111: Ausgleichsventil zum Druckausgleich
- 112: Gasleitung zwischen Druckbehälter und Gehäuse
- 113: Tiegel

- 201: Vorrichtung zum Formen des Schüttbetts auf dem Förderband
- 202: Verbindungsrohr
- 203: Absperrvorrichtung
- 204: Vorratsbehälter
- 205: Förderband
- 206: Laufrichtung des Förderbandes
- 207: Offene Seite des Halbrohres der Vorrichtung zum Formen des Schüttbetts auf dem Förderband
- 208: Schüttbett des Dotierstoffes

- 301: poröses Trennelement
- 302: Rohr zum Transport des Dotierstoffes
- 303: Haltevorrichtung für das Rohr
- 304: Auffangtrichter, Auffangeinrichtung

### Detaillierte Beschreibung erfindungsgemäßer Ausführungsbeispiele

Die Vorrichtung zum Ziehen eines dotierten Kristalls nach Czochralski, die es ermöglicht während des Ziehens Dotierstoff kontinuierlich zuzudosieren, umfasst eine Vorrichtung zum Ziehen eines Kristalls nach dem Verfahren von Czochralski.

Wie in **Abbildung 1** gezeigt, wird der Kristall (**105**) aus der Schmelze (**101**) gezogen, wobei ein oder mehrere Hitzeschilder (**102**) die Strahlungswärme begrenzen. Die Dotierung der Schmelze (**101**) findet dabei statt, indem der Dotierstoff aus einem Vorratsbehälter (**108**), der sich in einem Gehäuse (**107**) befindet, über ein Förderband (**106**) in einen Auffangtrichter (**110**) befördert wird, von dem es über ein Rohr auf ein poröses Trennelement (**104**) fällt.

Ein wesentliches Merkmal der Erfindung ist ein Förderband (**106**). Es hat die Aufgabe, Dotierstoff zu befördern. Der Dotierstoff, bevorzugt Arsen, kann besonders bevorzugt aus Bruch mit einer geeigneten Korn-Größenverteilung bestehen; alternativ auch aus Granulat oder geeigneten Arsenverbindungen wie beispielsweise Arsen-siliziden, -oxiden, oder Arsenaten. Weitere bevorzugte Dotierstoffe sind: Se, Bi.

Das Bandmaterial des Förderbandes ist dabei bevorzugt so konstruiert, dass es im Ambiente der Ziehanlage funktionsfähig ist. Insbesondere ist die Funktionsfähigkeit im Vakuum (bis 10 mbar), bei Strahlungstemperaturen bis 150 °C, chemisch resistent gegen die gewählte Dotierstoffverbindung und sollte weder Partikel noch flüchtige Substanzen emittieren. Die Erfinder haben erkannt, dass die dabei bevorzugten Bandmaterialien aus trockenen Fluorkautschuken bestehen.

Die Funktion wird ermöglicht durch einen Antrieb, der mittels eines Motors erfolgt, der besonders bevorzugt außerhalb des Vakuumbereichs der Ziehanlage angeordnet ist.

Die Übertragung der Antriebskraft erfolgt mittels einer Welle, die als Drehdurchführung für Vakuum ausgestaltet ist. Der Antriebsmotor selbst ist bevorzugt als Elektromotor ausgeführt, besonders bevorzugt als sogenannter Steppermotor. Das Drehmoment wird bevorzugt durch ein Getriebe erhöht. Das Getriebe kann bevorzugt mit Hilfe von Zahnrädern ausgeführt sein; genauso möglich ist ein Kettentrieb- oder ein Riemenantrieb.

Eine Vorrichtung zum Formen des Schüttbetts auf dem Förderband (**109**) ist maßgebend für den Fluss des Dotierstoffs und den Querschnitt des daraus entstehenden Schüttbetts (**208**). Für Montagezwecke ist besonders bevorzugt eine Absperrvorrichtung (**203**) integriert, mit der der Nachfluss an Dotierstoff gestoppt werden kann. Die Ausführung ist ein auf Auf/Zu beschränkendes Steuermittel; bevorzugt ausgeführt als Hahn oder Schieber.

Der lichte Durchmesser der Rohrleitungen muss ausreichend groß sein, damit ein Fluss des Dotierstoffs ohne Stockungen ermöglicht wird. Im Falle von beispielsweise Granulat ist dies mindestens der fünffache Wert des Durchmessers der größten Korngröße der angegebenen Korngrößenverteilung.

Durch eine fortschreitende Bewegung des Förderbandes wird Dotierstoff transportiert, der über ein Rohr zum Nachfließen gebracht wird. In einer den Querschnitt vorgebenden Einrichtung (**109, 201**) wird dabei gewährleistet, dass ein Schüttbett (**006**) entsteht, das über seine die ganze Länge ein möglichst hohes Gleichmaß im Querschnitt aufweist und dadurch einen linearen Zusammenhang zwischen Vorschub und Dotiermasse sicherstellt. Beginn und Ende des Schüttbetts, bei dem dieser Zusammenhang noch nicht oder nicht mehr linear ist, dürfen maximal 20 % der Länge des Schüttbetts aufweisen.

Die Erfinder haben erkannt, dass es besonders vorteilhaft ist, wenn die Vorrichtung zum Formen des Schüttbetts auf dem Förderband ein Halbrohr ist, dessen Durchmesser kleiner ist als die Breite des Förderbandes. Besonders wichtig dabei ist, dass die Vorrichtung auf einer Seite geschlossen und die andere Seite offen ist, und so über dem Förderband angeordnet ist, dass die offene Seite in Richtung des Förderns des Dotierstoffes zeigt. Damit ist gewährleistet, dass der Dotierstoff ohne nennenswerte zusätzliche Kontamination transportiert werden kann und die Form des aufgeprägten Schüttbetts des Dotierstoffes über die gesamte Länge ein maximal mögliches Gleichmaß aufweist.

Die Position der Vorrichtung zum Formen des Schüttbetts ist bevorzugt so über dem Förderband festgelegt, dass der minimale Abstand zum Förderband weniger als die Untergrenze der Korngrößenverteilung des Dotierstoffs beträgt. Zum einen wird damit ein Verkeilen von Granulat zwischen Vorrichtung und Förderband vermieden und zum anderen auch vermieden, dass Dotierstoff am Förderband vorbeifällt.

Die Unterkante der Vorrichtung zum Formen des Schüttbetts ist dabei bevorzugt so ausgeführt, dass sie in Richtung der Förderung mit dem Förderband einen minimalen offenen Winkel von weniger als 3°, besonders bevorzugt weniger als 1° ausbildet.

Die Vorrichtung zum Formen des Schüttbetts ist besonders bevorzugt aus Borosilikatglas (Laborglas, z.B. Duran^{®}) gefertigt.

Der Vorratsbehälter (**108**) beinhaltet einen Vorrat an Dotierstoff. Die Masse des Vorrats entspricht mindestens der für den Ziehprozess benötigten Masse.

Der Vorratsbehälter ist bevorzugt derart ausgestaltet, dass er zum Befüllen an einer toxikologisch einwandfreien Befüllstation geeignet ist. Darüber hinaus sind idealerweise die besonderen Anforderungen an Reinheit (Metalle) und Reinraum (Partikel) berücksichtigt.

Das bevorzugte Konstruktionsmaterial des Vorratsbehälters ist Borosilikatglas (Laborglas, z.B. Duran^{®}). Besonders bevorzugt sind sowohl Vorratsbehälter (**108**), als auch Absperreinrichtung (**203**) und die Vorrichtung zum Formen des Schüttbetts (**109**) einteilig ausgeführt.

Das Gehäuse (**107**) ist eine Erweiterung des Vakuumbereichs der Ziehanlage. Es ermöglicht den Betrieb der beschriebenen Einrichtungen während des Kristallziehens.

Besonders bevorzugt ist das Gehäuse (**107**) mit einer wasserführenden Kühlung, beispielsweise als Doppelmantel, ausgestaltet. Sichtfenster auf bewegliche Teile erleichtern die Bedienung sowie Kontrolle. Alle beweglichen Teile (Förderband, Vakuumdrehdurchführung, Getriebe und Antriebsmotor) sind mechanisch fest mit dem Gehäuse verbunden.

Direkt unterhalb des Kleinförderbandes befindet sich bevorzugt eine Auffangeinrichtung (**110**), die als Auffangtrichter ausgeführt sein kann, welche in ein Rohr (**302**) übergeht. Der obere Durchmesser der Auffangeinrichtung ist bevorzugt mindestens so groß wie die Breite des Schüttbetts des Dotierstoffs, bevorzugt mindestens dreimal so groß.

Der Durchmesser des Rohres (**302**) ist bevorzugt derart gewählt, dass es beim Betrieb nicht zu Verstopfungen führt. Dies ist dadurch zu gewährleisten, dass der Innendurchmesser des Rohres mindestens fünfmal so groß ist, wie die obere Grenze der Korngrößenverteilung des verwendeten Dotierstoffs.

Das Rohr (**302**) führt den herabrieselnden, zunächst noch festen Dotierstoff in einen definierten Bereich der Kristallziehanlage über der Schmelze, an dem die Umgebungsbedingungen (Druck, Temperatur und Partialdruck des Dampfes des Dotierstoffes) eine Sublimation desselben gewährleisten. Der definierte Bereich der Kristallziehanlage ist bevorzugt so gewählt, dass durch ein Schauglas der Sublimationsvorgang optisch zu verfolgen ist.

Zwischen dem Bereich mit dem erweiterten Durchmesser und dem Rohr ist eine Haltevorrichtung für das Rohr (**303**) installiert, so dass das Rohr dort einfach befestigt werden kann. Die Haltevorrichtung für das Rohr (**303**) ist vorzugsweise aus einen Ring aus Polymer gefertigt und schließt mit dem Gehäuse gasdicht ab.

An dem der Schmelze zugewandten Seite des Rohres ist das Rohr mit einem porösen Trennelement (**301**) verschlossen, das bewirkt, dass keine Partikel in die Schmelze gelangen können, jedoch Gase (sublimierter Dotierstoff) hindurchdiffundieren können. Die Erfinder haben erkannt, dass es von großer Bedeutung ist, welches Material für dieses poröse Trennelement verwendet wird. Wird beispielsweise wie in WO2020/123074 A1 angeregt, ein ausschließlich festes Material verwendet, kann es trotzdem vorkommen, dass kleinste Partikel, die vermutlich beim Aufprall auf das feste Hindernis entstehen, durch das poröse Trennelement in die Schmelze kommen und dort zum Versetzen des Kristalls (also zum Totalausfall) führen.

Das poröse Trennelement (**301**) ist daher bevorzugt aus einer Wolle aus Silica Glas gefertigt. Ganz besonders bevorzug ist das poröse Trennelement (**301**) auf der Silicium zugewandten Seite aus einem harten porösen Material, bevorzugt aus Quarzglas und auf der dem Silicium abgewandten Seite aus einer Wolle aus Silica Glas gefertigt.

Ist der Dotierstoff sublimiert, vermischt sich sein Gas mit dem in dem bereits vorhandenen Gas und kann er durch das poröse Trennelement (**301**) in Richtung flüssiges Silicium diffundieren.

Das vorherrschende Gas in einer Kristallziehanlage ist in aller Regel Argon. Unter bestimmten Voraussetzungen können auch Beimengungen von Stickstoff vorhanden sein.

In einer Kristallziehanlage nach Czochralski wird ein besonderes Augenmerk daraufgelegt, dass der Gasstrom aus dem flüssigen Silicium ausgeschiedene Komponenten aus Sauerstoff und Silicium (SiₓO_{y}) schnellstmöglich abtransportiert wird, da es sonst innerhalb der Anlage zu Ablagerungen kommen kann, die beim Öffnen der Anlage nach dem Ziehen des Kristalls zu Problemen führen könnte.

Argon dient daher bevorzugt auch als Trägergas, das dem Vorratsbehälter und dem Rohr beaufschlagt ist. Besonders bevorzugt wird ein Gasstrom im Rohr etabliert, der in Richtung des flüssigen Siliciums führt. Dies hat zwei Effekte: Zum einen werden keine Gase, die beim Kristallziehen entstehen in die Dotierungsvorrichtung transportiert, was auch hier bei der Demontage und Neubeschickung zu Problemen führen könnte und zum anderen wird sichergestellt, dass kein sublimierte Dotierstoff in den Vorratsbehälter oder das Rohr rückströmt, was u.a. zu erheblichen toxikologischen Gefährdungen führen könnte (Arsen).

Für den Fall, dass der Druckunterschied zwischen dem Vorratsbehälter und der Ziehanlage ungewollt zu groß wird, ist bevorzugt ein Überdruckventil oder ein Ausgleichsventil zum Druckausgleich (**111**) in einer zusätzlichen Leitung zwischen Vorratsbehälter und Ziehanlage installiert.

Die Position der dem flüssigen Silicium zugewandten Seite des Rohrs (**302**) sich bevorzugt unterhalb eines Hitzeschilds (**102**). Dies ermöglicht, das mit Dotierstoff angereicherte Transportgas in direkten Kontakt mit der Schmelze zu bringen, da nur auf diese Weise eine gewünschte Konzentrationserhöhung in der Schmelze herbeigeführt wird.

Um Ätzeffekte auf der Oberfläche des wachsenden Kristalls (020) durch den Arsendampf zu verhindern, darf die Endposition des Führungsrohrs nicht zu nah am Kristall liegen.

Die Erfinder haben erkannt, dass die beschriebene Vorrichtung zur Dotierung eines Kristalls während des Kristallziehens nach Czochralski besonders vorteilhaft ist. Der größte wirtschaftliche Nutzen stellt sich für die Verwendung der Vorrichtung ein, wenn der Durchmesser des Kristalls größer als 250 mm ist.

Bevorzugt ist es, einen ersten Kristall zu ziehen und ihn während des Ziehens mit Hilfe der genannten Vorrichtung mit einem ersten Dotierstoff zu dotieren, in dem die Geschwindigkeit des Förderbandes mit der Länge des wachsenden Kristalls korreliert ist. Dies geschieht bevorzugt in der Weise, dass an vordefinierten Stützstellen, die sich ganz besonders an den Positionen befinden, an denen der Kristall später in Stabstücke geschnitten wird, zunächst Sollgeschwindigkeiten für das Förderband festgelegt werden. Die Sollwerte für die Geschwindigkeit des Förderband außerhalb der Stützstellen wird dabei interpoliert.

Die Stützstellen bilden also ein 2-er Tupel aus Länge des Kristalls und Geschwindigkeit des Förderbandes.

Nachdem der erste Kristall gezogen ist, wird der Stab bezüglich des spezifischen Widerstands vermessen. Bevorzugt wird er dazu in Stabstücke geschnitten, deren Stirnflächen mit einer Widerstandsmessung vermessen werden.

Die so erhaltenen Messwerte werden mit dem gewünschten Verlauf des Widerstandes entlang seiner Achse verglichen und der Unterschied zwischen Messwert und Wunschwert gebildet.

Dieser Unterschied wird anschließend verwendet, um neue, veränderte Stützstellen für den zweiten Kristall zu verwenden.

Dieses Verfahren kann besonders bevorzugt weiter wiederholt werden, um Kristalle zu produzieren, die möglichst nahe einem gewünschten Verlauf des Widerstands entlang der Achse des Kristalls sind.

Ganz besonders bevorzugt ist das Verfahren, indem eine zweiter Dotierstoff dem Polysilicium im Tiegel beigemengt wird. Das Verfahren kann damit zum, Beispiel Kristalle erzeugen, die ein besonders flaches axiales Widerstandsprofil haben.

Bevorzugt ist der erste Dotierstoff Arsen. Besonders bevorzugt enthält der zweite Dotierstoff Bor.

Die so erhaltenen Kristalle werden bevorzugt mittels einer Säge in Stabstücke geschnitten, bevor sie mittels einer Drahtsäge in Halbleiterscheiben geschnitten werden. Bevorzugt werden die so erhaltenen Halbleiterscheiben poliert und optional mit einer epitaktisch aufgebrachten Schicht aus Silizium versehen.

## Patentansprüche

1. Vorrichtung zur Herstellung eines dotierten Kristalls nach Czochralski, umfassend
einen Druckbehälter (**103**),
einen im Druckbehälter befindlichen Tiegel (**113**), der eine Schmelze aus flüssigem Silicium (**101**) beinhalten kann
und eine Vorrichtung zum Dotieren der Schmelze, enthaltend ein Gehäuse (**107**),
einen Vorratsbehälter zum Vorhalten eines Dotierstoffes (**108**),
ein Förderband zum Fördern des Dotierstoffes (**106**),
eine Vorrichtung zum Formen eines Schüttbetts auf dem Förderband (**109**),
ein Rohr (**110**), in dessen erstes Ende Dotierstoff vom Förderband gelangen kann und dessen zweites Ende in Richtung des flüssigen Siliciums (**101**) zeigt und gegenüber dem flüssigen Silicium mit einem porösen Trennelement (**104**) abgeschlossen ist,
**dadurch gekennzeichnet, dass**
die Vorrichtung zum Formen des Schüttbetts (**109**) auf dem Förderband ein Halbrohr mit einem Durchmesser kleiner als die Breite des Förderbandes (**106, 205**) beinhaltet, das auf einer Seite geschlossen und die andere Seite offen ist, und so über dem Förderband (**106, 205**) angeordnet ist, dass die offene Seite in Richtung des Förderns (**206**) des Dotierstoffes (**208**) zeigt.

2. Vorrichtung nach Anspruch 1, **dadurch gekennzeichnet, dass** der minimale Abstand zwischen Halbrohr und Förderband (**106, 205**) kleiner ist als die minimale Größe der Korngrößenverteilung des Dotierstoffs.

3. Vorrichtung nach einem der vorstehenden Ansprüche, **dadurch gekennzeichnet, dass** die Vorrichtung zum Formen des Schüttbetts (**109**) auf dem Förderband (**106, 205**) mit einem zweiten Rohr (**202**) mit dem Vorratsbehälter (**204**) verbunden ist und mittels Absperrvorrichtung (**203**) geschlossen werden kann, so dass ein weiterer Fluss von Dotierstoff unterbunden werden kann.

4. Vorrichtung nach einem der vorstehenden Ansprüche, **dadurch gekennzeichnet, dass** das Förderband (**106, 205**) aus trockenen Fluorkautschuken aufgebaut ist.

5. Vorrichtung nach einem der vorstehenden Ansprüche, **dadurch gekennzeichnet, dass** das poröse Trennelement (**104**) aus Quarzglaswolle besteht.

6. Vorrichtung nach einem der vorstehenden Ansprüche, **dadurch gekennzeichnet, dass** der das Gehäuse (**107**) eine wasserführende Kühlung aufweist.

7. Vorrichtung nach einem der vorstehenden Ansprüche, **dadurch gekennzeichnet, dass** die Vorrichtung zum Formen des Schüttbetts (**109**) aus Borosilikatglas gefertigt wurde.

8. Verfahren zur Herstellung eines dotierten monokristallinen Stabes aus Silicium, umfassend
das Ziehen eines ersten Kristalls aus einem Tiegel in einer Ziehanlage nach Czochralski,
Dotieren des ersten Kristalls unter Verwendung der Vorrichtung aus Anspruch 1 mit einem ersten Dotierstoff,
wobei die Geschwindigkeit des Förderbandes so eingestellt wird, dass sie vordefinierten Stützstellen bestehend aus 2-er Tupel aus Soll-Geschwindigkeit und Länge des gezogenen ersten Kristalls folgt,
das Bestimmen des axialen Widerstandsverlaufs des ersten Kristalls,
das Modifizieren einer Soll-Geschwindigkeit der vordefinierten Stützstellen entsprechend des axialen Widerstandsverlaufes des ersten Kristalls,
das Ziehen eines zweiten Kristalls unter Verwendung der modifizierten Stützstellen.

9. Verfahren nach Anspruch 8, **dadurch gekennzeichnet, dass** vor dem Ziehen des ersten und des zweiten Kristalls jeweils ein Tiegel mit Polysilicium befüllt wird, dem eine vordefinierte Menge eines zweiten Dotierstoffes beigefügt wird.

10. Verfahren nach Anspruch 9, **dadurch gekennzeichnet, dass** der erste Dotierstoff vorwiegend Arsen und der zweite Dotierstoff vorwiegend Bor enthält.

11. Verfahren nach Anspruch 9, **dadurch gekennzeichnet, dass** der zweite Kristall in Stabstücke geschnitten wird, wobei die Position der Schnitte den Positionen der vordefinierten Stützstellen entspricht.

12. Verfahren nach Anspruch 9, **dadurch gekennzeichnet, dass** der zweite Kristall so gezogen wird, dass er einen Durchmesser von größer 250 mm hat.

13. Verfahren nach Anspruch 11, **dadurch gekennzeichnet, dass** die Stabstücke mittels einer Drahtsäge in Halbleiterscheiben geschnitten werden, poliert werden und optional mit einer epitaktisch aufgebrachten Schicht aus Silizium versehen werden.

## Claims

1. Apparatus for producing a doped Czochralski crystal, comprisinga pressure vessel (103),a crucible (113) located in the pressure vessel and able to contain a melt of liquid silicon (101),and an apparatus for doping the melt, comprisinga housing (107), a reservoir vessel for holding a dopant (108), a conveyor belt for conveying the dopant (106), an apparatus for shaping a dumped bed on the conveyor belt (109),a pipe (110) whose first end is accessible by dopant from the conveyor belt and whose second end points in the direction of the liquid silicon (101) and is closed off from the liquid silicon with a porous separating element (104),characterized in thatthe apparatus for shaping the dumped bed (109) on the conveyor belt comprises a half-pipe having a diameter smaller than the width of the conveyor belt (106, 205), said half-pipe being closed on one side, the other side being open, and being arranged over the conveyor belt (106, 205) in such a way that the open side points in the direction of conveyance (206) of the dopant (208).

2. Apparatus according to Claim 1, **characterized in that** the minimum distance between half-pipe and conveyor belt (106, 205) is smaller than the minimum size of the particle size distribution of the dopant.

3. Apparatus according to either of the preceding claims, **characterized in that** the apparatus for shaping the dumped bed (109) on the conveyor belt (106, 205) is connected by a second pipe (202) to the reservoir vessel (204) and can be closed by means of shutoff apparatus (203), so that a further flow of dopant can be halted.

4. Apparatus according to any of the preceding claims, **characterized in that** the conveyor belt (106, 205) is constructed of dry fluoro rubbers.

5. Apparatus according to any of the preceding claims, **characterized in that** the porous separating element (104) consists of fused quartz wool.

6. Apparatus according to any of the preceding claims, **characterized in that** the housing (107) comprises a water-carrying cooling system.

7. Apparatus according to any of the preceding claims, **characterized in that** the apparatus for shaping the dumped bed (109) has been fabricated from borosilicate glass.

8. Process for producing a doped monocrystalline ingot of silicon, comprising the pulling of a first crystal from a crucible in a Czochralski pulling unit, doping of the first crystal using the apparatus from Claim 1 with a first dopant,the velocity of the conveyor belt being set such that it follows predefined support points consisting of a 2-tuple formed from target velocity and length of the pulled first crystal, the determining of the axial resistance profile of the first crystal, the modifying of a target velocity of the predefined support points in accordance with the axial resistance profile of the first crystal, the pulling of a second crystal using the modified support points.

9. Process according to Claim 8, **characterized in that** the pulling of the first and of the second crystal is preceded in each case by the filling of a crucible with polysilicon which is admixed with a predefined amount of a second dopant.

10. Process according to Claim 9, **characterized in that** the first dopant comprises primarily arsenic and the second dopant comprises primarily boron.

11. Process according to Claim 9, **characterized in that** the second crystal is cut into ingot pieces, the position of the cuts corresponding to the positions of the predefined support points.

12. Process according to Claim 9, **characterized in that** the second crystal is pulled such that it has a diameter of greater than 250 mm.

13. Process according to Claim 11, **characterized in that** the ingot pieces are cut by means of a wire saw into semiconductor wafers, and are polished and optionally provided with an epitaxially applied layer of silicon.

## Revendications

1. Dispositif pour la préparation d'un cristal dopé selon Czochralski, comprenant
un récipient sous pression (103),
un creuset (113) se trouvant dans le récipient sous pression, qui peut contenir une masse fondue de silicium liquide (101) et
un dispositif pour le dopage de la masse fondue, contenant un boîtier (107),
un réservoir pour la tenue à disposition d'une substance de dopage (108),
une bande transporteuse pour le transport de la substance de dopage (106),
un dispositif pour la formation d'un lit en vrac sur la bande transporteuse (109),
un tuyau (110), dans la première extrémité duquel de la substance de dopage provenant de la bande transporteuse peut arriver et dont la deuxième extrémité pointe dans le sens vers le silicium liquide (101) et qui est fermé par rapport au silicium liquide par un élément de séparation poreux (104),
**caractérisé en ce que** le dispositif pour la formation du lit en vrac (109) sur la bande transporteuse comporte un demi-tuyau présentant un diamètre inférieur à la largeur de la bande transporteuse (106, 205) qui est fermé d'un côté et ouvert de l'autre côté et qui est agencé au-dessus de la bande transporteuse (106, 205) de manière telle que le côté ouvert pointe dans le sens du transport (206) de la substance de dopage (208).

2. Dispositif selon la revendication 1, **caractérisé en ce que** la distance minimale entre le demi-tuyau et la bande transporteuse (106, 205) est inférieure à la grosseur minimale de la distribution granulométrique de la substance de dopage.

3. Dispositif selon l'une des revendications précédentes, **caractérisé en ce que** le dispositif pour la formation du lit en vrac (109) sur la bande transporteuse (106, 205) est relié à l'aide d'un deuxième tuyau (202) au réservoir (204) et peut être fermé au moyen d'un dispositif de fermeture (203) de telle sorte qu'un flux supplémentaire de substance de dopage peut être empêché.

4. Dispositif selon l'une des revendications précédentes, **caractérisé en ce que** la bande transporteuse (106, 205) est constituée de caoutchoucs fluorés secs.

5. Dispositif selon l'une des revendications précédentes, **caractérisé en ce que** l'élément de séparation poreux (104) est constitué de laine de verre de quartz.

6. Dispositif selon l'une des revendications précédentes, **caractérisé en ce que** le boîtier (107) présente un refroidissement à guidage d'eau.

7. Dispositif selon l'une des revendications précédentes, **caractérisé en ce que** le dispositif pour la formation du lit en vrac (109) a été fabriqué en verre borosilicaté.

8. Procédé pour la préparation d'une tige monocristalline dopée en silicium, comprenant
le tirage d'un premier cristal à partir d'un creuset dans une installation de tirage selon Czochralski,
le dopage du premier cristal à l'aide du dispositif selon la revendication 1 par une première substance de dopage, la vitesse de la bande transporteuse étant réglée de manière telle qu'elle suit des points d'appui prédéfinis constitués de 2-uplets de la vitesse de consigne et de la longueur du premier cristal tiré,
la détermination de l'allure axiale de la résistance du premier cristal,
la modification d'une vitesse de consigne des points d'appui prédéfinis en fonction de l'allure axiale de la résistance du premier cristal,
le tirage d'un deuxième cristal à l'aide des points d'appui modifiés.

9. Procédé selon la revendication 8, **caractérisé en ce qu'**avant le tirage du premier et du deuxième cristal, un creuset est à chaque fois rempli de polysilicium, auquel est ajouté une quantité prédéfinie d'une deuxième substance de dopage.

10. Procédé selon la revendication 9, **caractérisé en ce que** la première substance de dopage contient principalement de l'arsenic et la deuxième substance de dopage contient principalement du bore.

11. Procédé selon la revendication 9, **caractérisé en ce que** le deuxième cristal est découpé en morceaux de tige, la position des découpes correspondant aux positions des points d'appui prédéfinis.

12. Procédé selon la revendication 9, **caractérisé en ce que** le deuxième cristal est tiré de manière telle qu'il présente un diamètre supérieur à 250 mm.

13. Procédé selon la revendication 11, **caractérisé en ce que** les morceaux de tige sont découpés au moyen d'une scie à fil en tranches semi-conductrices, sont polis et éventuellement pourvus d'une couche de silicium appliquée par épitaxie.
